# EUROPEAN PATENT APPLICATION

(11) **EP 4 832 243 A1**
(43) Date of publication of application: **28.10.2026**
(21) Application number: 24906890.9
(22) Date of filing: 15.10.2024
(51) Int. Cl.: H01Q 1/28, H01Q 1/08, H05K 1/02

(54) **ELECTROCONDUCTIVE CIRCUIT PANEL FOR UNFOLDING ANTENNA**

(30) Priority: 18.12.2023 JP 2023213328
(71) Applicant: Seiren Co., Ltd., Fukui-shi Fukui 918-8560 (JP)
(72) Inventor: INAGAKI, Shunsuke, Fukui-shi, Fukui 918-8560 (JP); TAKEUCHI, Tomoya, Fukui-shi, Fukui 918-8560 (JP); TAKAHASHI, Toshiyuki, Fukui-shi, Fukui 918-8560 (JP)
(74) Representative: Hoffmann Eitle
(86) International application number: PCT/JP2024/036700
(87) International publication number: WO 2025/134502

(57) **Abstract**

An object of the present invention is to provide an electroconductive circuit panel for an unfolding antenna that makes it possible to provide a highly reliable antenna capable of maintaining shape stability and high transmission/reception performance when unfolded, without deterioration of a circuit or a panel even with repeated folding and unfolding.

Provided is an electroconductive circuit panel for an unfolding antenna, which includes a panel composite material configured from a fiber base material and an electroconductive circuit pattern formed on the fiber base material, and which can assume a folded state and an unfolded state, wherein: there are provided a soft region that exhibits a low bending strength and a hard region that exhibits a bending strength higher than that of the soft region;
the electroconductive circuit pattern has a resistance increase rate of 600% or less in the soft region, as measured in an MIT bending test in conformance with JIS-P8115;
and the electroconductive circuit panel for the unfolding antenna can be folded along the soft region.

## Description

### Technical Field

The present invention relates to an electroconductive circuit panel for an unfolding antenna useful for artificial satellites or the like. More particularly, the present invention relates to a highly reliable electroconductive circuit panel for an unfolding antenna capable of suppressing deterioration at a folding portion.

### Background Art

As satellite communications expand, there is a need for a large-sized antenna. However, since a storage space is limited at the time of launch, the antenna is stored in a small folded state and then unfolded in orbit after launch to become an antenna.

Such unfolding antennas are required reliability in unfolding and accuracy in transmission/reception performance after unfolded. However, repeated folding and unfolding may lead to problems of physical deterioration of a panel in folded part and also deterioration of performances as an antenna.

In recent years, the deployment system for such large antennas have attracted global attention, and various deployment manners have been proposed. Patent Document 1 discloses a deployable membrane structure for antennas having a high-stiffness region and a low-stiffness region.

Regardless of the systems, in order for an antenna to be foldable for compact storage and capable of performing transmission/reception with high reliability after deployment, it is necessary to improve bending resistance of a folding portion or a bent part while maintaining appropriate rigidity. When the folding portion deteriorates, the accuracy of transmission/reception may decrease, or the overall physical strength of the antenna may be reduced.

### Prior Art Documents

### Patent Document

Patent Document 1: Jpn. Pat. Kokai No. 2021-530126

### Disclosure of the Invention

### Problems to be Solved by the Invention

An object of the present invention is to provide an electroconductive circuit panel for an unfolding antenna capable of providing a highly reliable antenna capable of maintaining shape stability and high transmission/reception performance when unfolded, without deterioration of a circuit or a panel even with repeated folding and unfolding.

### Means for Solving the Problems

As a result of inventive study, the inventors have found that the above problems can be solved by pre-determining folding portions during manufacturing and devising a combination of fiber base materials, resins, metal films and the like, so that the bending strength in the region corresponding to the folding portion becomes lower than the bending strength in other regions, thereby completing the present invention.

That is, the present invention relates to the following electroconductive circuit panel for an unfolding antenna:
(1) An electroconductive circuit panel for an unfolding antenna, which comprises a panel composite material composed of a fiber base material and an electroconductive circuit pattern formed on said fiber base material which can be in a folded state and an unfolded state,
   wherein there are provided a soft region that exhibits a low bending strength and a hard region that exhibits a bending strength higher than that of the soft region,
   said electroconductive circuit pattern has a resistance increase rate of 600% or less in the soft region, as measured in an MIT bending test in conformance with JIS-P8115, and
   said electroconductive circuit panel can be folded along the soft region.
(2) The electroconductive circuit panel for an unfolding antenna according to (1), wherein the bending strength of the soft region is 0.19 N or less and the bending strength of the hard region is 0.2 N or more.
(3) The electroconductive circuit panel for an unfolding antenna according to (1), wherein the difference between the bending strength of the soft region and the bending strength of the hard region is 0.2 N or more.
(4) The electroconductive circuit panel for an unfolding antenna according to (1), wherein the line width of said electroconductive circuit pattern in the soft region is 1.0 mm or more.
(5) The electroconductive circuit panel for an unfolding antenna according to (1), wherein the metal content of the electroconductive circuit pattern in the soft region is 3 to 120 µg/mm².
(6) The electroconductive circuit panel for an unfolding antenna according to (1), wherein a surface resin layer is formed on at least one side of the panel composite material in at least the hard region.
(7) The electroconductive circuit panel for an unfolding antenna according to (6), wherein said surface resin layer is formed on at least one side of the panel composite material in both the soft region and the hard region, and the ratio of the amount of resin in the surface resin layer in the soft region to the amount of resin in the surface resin layer in the hard region is 1:20 or more by mass.
(8) The electroconductive circuit panel for an unfolding antenna according to (6), wherein the surface resin layer is made of polyurethane resin.
(9) The electroconductive circuit panel for an unfolding antenna according to (1), wherein the panel composite material comprises a plated metal film formed on said electroconductive circuit pattern.

### Effect of the Invention

The electroconductive circuit panel for an unfolding antenna of the present invention can be stored in a folded state and can be unfolded to expand the transmission/reception surface when used. It has a hard region and a soft region within a single panel. By folding along the soft region which has a low bending strength, flexibility and pre-reinforced resistance of the circuit to bending, deterioration of a circuit or a panel due to repeated folding and unfolding can be prevented, and shape stability at the time of deployment can be maintained. By setting the folding portion at the time of manufacture, an unfolding antenna or a deployable antenna having a high reliability can be obtained.

### Brief Description of the Drawings

[FIG. 1]

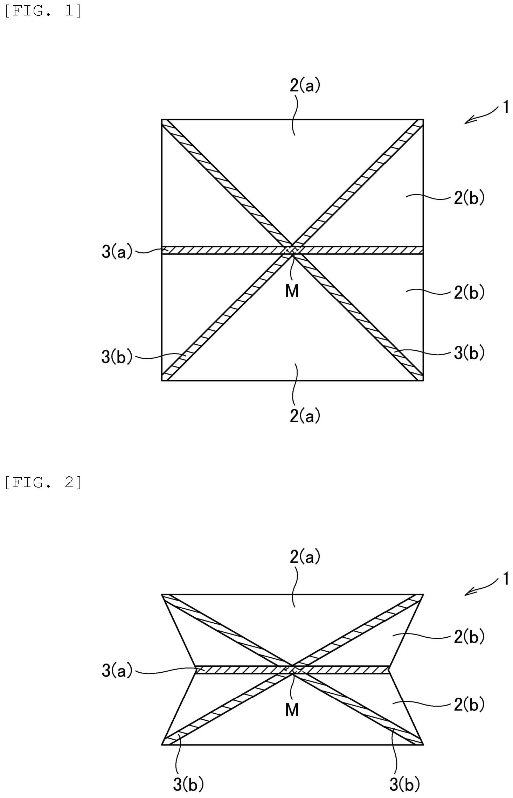

   FIG. 1 shows a plan view illustrating one embodiment of the electroconductive circuit panel for an unfolding antenna according to the present invention.
[FIG. 2]
   FIG. 2 shows a state in which the embodiment of an electroconductive circuit panel for an unfolding antenna according to the present invention shown in FIG. 1 is in the middle process of being folded.
[FIG. 3]

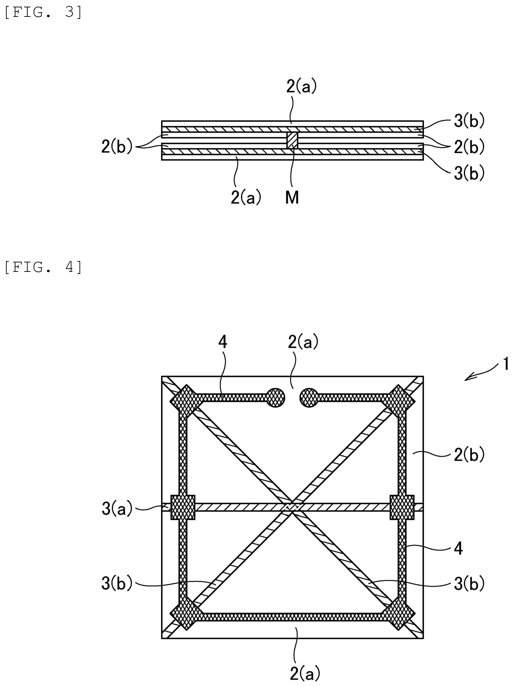

   FIG. 3 shows a state in which the embodiment of an electroconductive circuit panel for an unfolding antenna according to the present invention shown in FIG. 1 is fully folded.
[FIG. 4]
   FIG. 4 shows an electroconductive circuit pattern in the embodiment of an electroconductive circuit panel for an unfolding antenna according to the present invention shown in FIG. 1.
[FIG. 5]

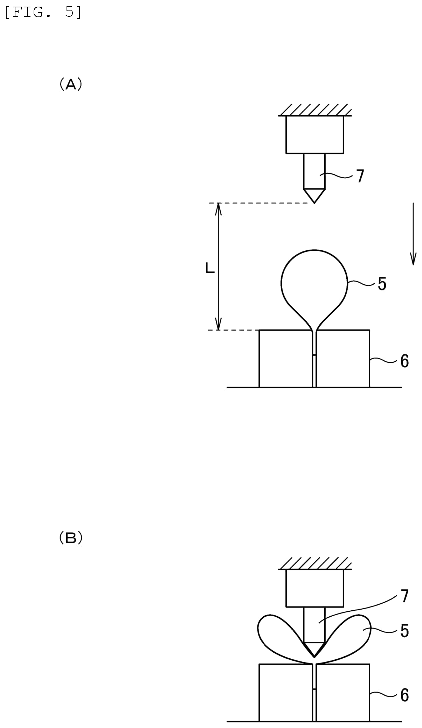

   FIG. 5 shows a schematic diagram illustrating the method for measuring a bending strength according to the present invention.
[FIG. 6]

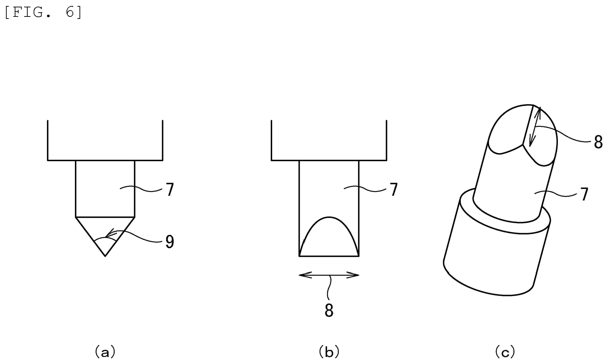

   FIG. 6 shows a schematic diagram illustrating the pressure element used for measuring a bending strength according to the present invention.

### Modes for Carrying Out the Invention

The electroconductive circuit panel of the present invention comprises a panel composite material composed of a fiber base material, or fiber substrate, and an electroconductive circuit pattern formed on said fiber base material a soft region that exhibits a low bending strength and a hard region that exhibits a bending strength higher than that of the soft region, wherein said electroconductive circuit pattern has a resistance increase rate of 600% or less in the soft region as measured in an MIT bending test in conformance with JIS-P8115. The electroconductive circuit panel is for an unfolding antenna or a deployable antenna that can take a folded state and an unfolded state, and is foldable along the soft region.

FIG. 1 shows a plan view illustrating an embodiment of the electroconductive circuit panel for an unfolding antenna according to the present invention. In FIG. 1, "1" represents the electroconductive circuit panel, "2(a)" and "2(b)" represent hard regions, "3(a)" and "3(b)" represent soft regions, and "M" represents a central part.

FIG. 2 shows a state in which the electroconductive circuit panel shown in FIG. 1 is in the middle process of being folded. FIG. 3 shows a state in which the electroconductive circuit panel shown in FIG. 1 is fully folded.

FIG. 4 is a diagram illustrating an embodiment of forming an electroconductive circuit pattern in the electroconductive circuit panel shown in FIG. 1, which is normally formed beneath the surface resin layer and may not be visible, in order to make it easier to understand. In FIG. 4, "4" represents the electroconductive circuit pattern.

In FIG. 1, the left and right soft regions "3(a)" are folded inward (in a state of valley-folding relative to the plane), and the diagonally positioned soft region "3(b)" is folded in a state of mountain-folding. The upper and lower edges are brought towards the center, and the central part "M" where the soft regions intersect is pulled towards the front, allowing the panel to be folded into a small, thin shape that is easy to unfold, and store (FIG. 3). However, this is only one embodiment of the present invention, and the present invention is not limited thereto.

### (1) Fiber Base Material

The electroconductive circuit panel of the present invention includes a panel composite material comprising a fiber base material (or a fiber substrate) and an electroconductive circuit pattern formed thereon. A fabric made of fiber material is preferably used as the fiber base material.

Examples of the fiber materials include, but are not limited to, natural fibers such as cotton, linen, wool, and silk; regenerated fibers such as rayon and cupra; semi-synthetic fibers such as acetate and triacetate; synthetic fibers such as polyamide (nylon 6, nylon 66, etc.) fibers, polyester (polyethylene terephthalate, polytrimethylene terephthalate, etc.) fibers, polyurethane, polyacrylic, aramid, and poly(p-phenylene benzobisoxazole); and inorganic fibers such as glass fibers, basalt fibers, and carbon fibers. From the viewpoint of versatility, flexibility and strength, synthetic fibers are preferred as fiber materials. Among these, polyimide fibers are particularly preferred for aerospace applications, and polyester fibers are particularly preferred for other general applications.

The thickness of the fiber base material is not particularly limited, but is preferably 10 to 5000 µm, and more preferably 50 to 1000 µm.

Examples of the fiber base materials include woven fabric, knitted fabric, and nonwoven fabric, and any one of these can be used. The shape of the yarn constituting the fiber base material is also not particularly limited.

### (2) Electroconductive Circuit Pattern

The fiber base material (fiber substrate) has an electroconductive circuit pattern formed on the surface thereof to constitute a panel composite material. The electroconductive circuit pattern can be formed on one side (front or back) or both sides of the fiber base material. When using a material having a relatively large thickness or a material made of fabric with low permeability as said fiber substrate, the pattern can be formed on only one side of the fiber substrate. In the case of forming the electroconductive circuit pattern on both sides of the fiber substrate, the resistance value can be kept low to enhance the sensitivity of the antenna. It is preferable that the electroconductive circuit pattern is formed on both sides of the fiber substrate.

Furthermore, the electroconductive circuit pattern may be formed not only on the surface of the fiber substrate but also to penetrate in the thickness direction of the fiber substrate. The electroconductive circuit pattern can also be in a state of permeating or penetrating from the front surface to the back surface of the fiber substrate . The electroconductive circuit pattern can form an electroconductive circuit individually or by connecting multiple electroconductive circuit patterns.

The electroconductive circuit pattern contains metal. The metal contained in the electroconductive circuit pattern is not particularly limited, but it can be one or more metals selected from gold, silver, copper, nickel, tin, iron, aluminum, platinum, palladium, rhodium, ruthenium, iridium, osmium, indium, rubidium, and cobalt, or a mixture or alloy of such metals. Among these, gold, silver, copper, nickel, and tin are preferred. Copper is particularly preferred due to its high conductivity and cost-effectiveness.

The form of the metal contained in the electroconductive circuit pattern is not particularly limited. In order to form a more fine electroconductive circuit pattern, it is preferable that the metal contains metal particles. It is more preferable that the metal contains metal particles with an average particle diameter of 1 to 200 nm.

A plating process can be carried out using these metal particles as a nucleus to deposit the same or different types of metals, which enables to increase the amount of metal to improve conductivity.

The average particle diameter of metal particles here refers to the primary particle diameter without considering aggregation, and can be expressed by the arithmetic average value of the spherical particle diameters (the diameter when each particle is converted to a sphere of the same volume) of 100 or more particles measured using any known method in the art, such as a transmission electron microscope (TEM).

In the present invention, the term "average particle diameter of metal particles" means the arithmetic average value of the spherical particle diameters of 100 metal particles measured using a transmission electron microscope.

The electroconductive circuit pattern can be formed in a free shape. A single electroconductive circuit pattern or a combination of multiple electroconductive circuit patterns can be formed to obtain a freely designed electroconductive circuit, whereby a highly accurate and complicated electroconductive circuit can be manufactured compactly with high density.

The electroconductive circuit pattern of the present invention can be formed on a fiber substrate preferably using an ink composition containing metal.

It is preferable to use a printing method for forming the electroconductive circuit pattern. Examples of printing methods include screen printing, gravure printing, inkjet printing, xerography, stamping, flexographic printing, offset printing, painting, and airbrushing. In either method, an ink composition containing metal can be used. Among these methods, an inkjet printing method is particularly preferred.

The ink composition containing metal is preferably an ink composition containing the above-described metal particles. In particular, it is preferable that it contains metal particles with an average particle diameter of 1 to 200 nm. Applying an ink composition containing metal particles of such an average particle diameter to the surface of a fiber substrate (fabric) enables for the metal particles to penetrate not only into the gaps in the structure of the fiber substrate, but also into the gaps in the yarns constituting the fiber substrate, that is, into the gaps between single fibers. As a result, the uniformity of the electroconductive circuit pattern thus formed can be improved to suppress occurrence of metal detachment.

Examples of the aforementioned ink composition include a dispersion liquid of metal particles. The dispersion liquid of metal particles refers to a solution in which metal particles are appropriately dispersed in a solvent. Since metal particles in a solvent tend to aggregate, a dispersant can be added to coat the surface of the metal particles so that aggregation can be suppressed and the dispersion of metal particles can be stabilized.

The aforementioned solvent is not particularly limited, but examples thereof include water, alcohol-based solvents (monoalcohol-based solvents, diol-based solvents, polyhydric alcohol-based solvents, etc.), hydrocarbon-based solvents, ketone-based solvents, ester-based solvents, ether-based solvents, glyme-based solvents, and halogen-based solvents. These solvents may be used individually or in combination of two or more.

As for the aforementioned dispersant, any known dispersant may be appropriately selected and used. Examples thereof include, but are not limited to, amine compounds and thiol compounds.

The amine compound is preferably an aliphatic amine compound, and more preferably an aliphatic amine compound with 4 to 10 carbon atoms in the alkyl portion. Examples of the aliphatic amine compounds include alkylamines such as octylamine, dodecylamine, and hexadecylamine, and alkenylamines such as oleylamine.

The thiol compound is preferably an aliphatic thiol compound. Examples of aliphatic thiol compounds include alkylthiols such as hexanethiol, pentanedithiol, decanethiol, and dodecanethiol.

The dispersant may be used individually or in a mixture of two or more. By using a dispersant with a small number of carbon atoms, detachment or decomposition can be achieved under an easier condition.

The proportion of metal particles in the ink composition is preferably 0.1 to 70% by mass, more preferably 1 to 60% by mass, and even more preferably 10 to 50% by mass, based on the total mass of the ink composition.

In addition to metal particles, solvents, and dispersants, the ink composition may also contain known additives for the purpose of adjusting its printability. Examples of such additives include thickeners and stabilizers.

The electroconductive circuit pattern in the electroconductive circuit panel of the present invention exhibits high bending resistance, at least in the soft region. In the soft region, in particular, bending resistance of the electroconductive circuit pattern is preferably 600% or less, more preferably 550% or less, and most preferably 500% or less, as measured by the resistance increase rate in the MIT bending test in accordance with JIS-P8115.

The lower limit of the resistance increase rate of the electroconductive circuit pattern in the soft region is not particularly limited, but is preferably 1% or more, more preferably 50% or more, even more preferably 120% or more, and particularly preferably 200% or more. Enhancing bending resistance of the electroconductive circuit pattern in the soft region enables to prevent deterioration of reliability of the circuit even with repeated folding and unfolding.

The bending resistance of the electroconductive circuit pattern in the hard region is not particularly limited. The electroconductive circuit pattern in the hard region may be formed without considering bending resistance, though it is possible to enhance bending resistance of the hard region to the same level as the soft region.

Bending resistance of the electroconductive circuit pattern in the hard region can be set to be lower than that in the soft region. For example, by using thinner wires for the electroconductive circuit pattern in the hard region than in the soft region, the degree of freedom in the circuits can be increased, or space can be saved.

The resistance increase rate of the electroconductive circuit pattern in the hard region according to the MIT bending test is not particularly limited. In the case that bending resistance of the electroconductive circuit pattern in the hard region can be set to be lower than that of the soft region, it may be higher than 600%, and further 650% or higher.

Means for enhancing bending resistance of the electroconductive circuit pattern are not particularly limited, but examples thereof include widening the line width of the pattern, increasing the amount of metal in the pattern, and increasing the thickness of the metal in the pattern.

Examples of the methods for widening the line width of the pattern include a method to use an inkjet printing method. The preferred line width of the electroconductive circuit pattern in the soft region is 1.0 mm or more, more preferably 3.0 mm or more, and particularly preferably 5.0 mm or more. The upper limit to the line width in the soft region is not particularly limited, but it is preferably 80 mm or less.

The line width of the electroconductive circuit pattern in the hard region is not particularly limited, but may be 4.9 mm or less, more preferably 2.9 mm or less. When bending resistance in the hard region can be set to be lower than that in the soft region, it may be 1.0 mm or less. The lower limit of the line width of the electroconductive circuit pattern in the hard region is not particularly limited, but is preferably 0.3 mm or more.

In the electroconductive circuit panel of the present invention, by designing the bending strength in the soft region to be lower to provide flexibility while enhancing the strength of the circuit, and designing the bending strength in the hard region which is the main part of the antenna performance to be higher than that in the soft region while increasing a degree of freedom in the electroconductive circuit pattern without considering strength, it is possible to maintain a good balance in overall antenna performance. Furthermore, deterioration of a circuit or a panel due to folding can be prevented, and shape stability when unfolding can be maintained, resulting in a highly reliable unfolding antenna.

When bending resistance in the hard region can be set to be lower than that in the soft region, the ratio of the line width of the soft region to the line width of the hard region is not particularly limited, but is preferably 5-20:1-3.

Means for increasing the amount of metal in the electroconductive circuit pattern include inkjet printing and lamination printing of the electroconductive layer by screen printing. Printing conditions can be set in advance at the time of printing so as to increase the number of lamination or the amount of ink ejected.

The amount of metal in the electroconductive circuit pattern in the soft region is preferably 3.0 µg/mm² or more, more preferably 5.0 µg/mm² or more, further preferably 10 µg/mm² or more, particularly preferably 30 µg/mm² or more, and more particularly preferably 35 µg/mm² or more. The upper limit thereof is not particularly limited, but it is preferably 120 µg/mm² or less, more preferably 100 µg/mm² or less, and particularly preferably 50 µg/mm² or less.

The amount of metal in the electroconductive circuit pattern in the hard region is not particularly limited, but may be 39.9 µg/mm² or less, or 29.9 µg/mm² or less. The lower limit is not particularly limited, but may be 3 µg/mm² or more, or even 5 µg/mm² or more. The amount of metal in the hard region may be about the same as that in the soft region, or it may be lower.

The ratio of metal content in the electroconductive circuit pattern between the soft and hard regions is not particularly limited, but the ratio [metal content in the soft region]:[metal content in the hard region] (mass ratio) is preferably 3:1 or less, more preferably 2:1 or less, and even more preferably 1.2:1 or less. The lower limit of the ratio [metal content in the soft region]:[metal content in the hard region] (mass ratio) is not particularly limited, but is preferably 0.8:1 or more, more preferably 0.9:1 or more, and even more preferably 1:1 or more.

The metal content of the electroconductive circuit pattern is defined as the metal content per unit area (µg/mm²). The term "area" in the present invention refers to the area of the panel composite material viewed in a plan view, without considering the thickness, voids, or surface irregularities of the panel composite material comprising the fiber substrate.

The amount of metal in each region, soft region and hard region, of the electroconductive circuit pattern is measured by the following method:
- The region to be measured is cut out together with the fiber substrate to form a sample, and its area is measured. As mentioned above, the area to be measured is an area viewed in a plan view without considering thickness, voids, or surface irregularities.
- Next, the cut-out sample is immersed in a nitric acid solution diluted to a concentration of 50% by mass to completely dissolve the metal layer.
- The nitric acid aqueous solution in which the metal has been dissolved thus obtained is diluted to a predetermined concentration, and the metal concentration in the aqueous solution is measured by atomic absorption spectrometry. The amount of metal per unit area (µg/mm²) is calculated from the area of the cut-out sample and the metal concentration obtained by atomic absorption spectrometry.

### (3) Plated Metal Film

In the present invention, a plated metal film may be formed on the electroconductive circuit pattern by further applying a metal plating treatment as necessary, which makes it possible to further increase the amount of metal in the electroconductive circuit pattern, and to manufacture an electroconductive circuit panel with even higher conductivity. In addition, the adhesion strength of the electroconductive circuit pattern to the fiber substrate can be improved to prevent the pattern from falling off. In the present invention, when a plated metal film is formed on the electroconductive circuit pattern in this way, the term "electroconductive circuit pattern" may include both the electroconductive circuit pattern and the plated metal film.

Examples of metal plating include electroplating and electroless plating, and either is acceptable. It is preferable to use electroless plating. The metal used for plating may be the same as or different from the metal particles contained in the ink composition. Preferably, the metal used for plating is the same as the metal particles contained in the ink composition. Furthermore, it is preferable to use copper for both the metal particles contained in the ink composition and the metal used for plating.

Conventionally known methods can be employed for the metal plating process, and there are no particular limitations on the chemicals, equipment, or conditions used. Optimal conditions can be selected and implemented depending on the type and amount of metal to be deposited.

In the case of performing electroless plating, for example, it can be carried out by printing an electroconductive circuit pattern onto a fiber substrate using an ink composition, followed by removing the solvent of the ink composition by heating or drying, and then immersing the fiber substrate in an electroless plating solution.

In the present invention, when a plated metal film is formed on the electroconductive circuit pattern as necessary, the amount of metal in each of the soft and hard regions is the sum of the amount of metal derived from the metal-containing ink composition, imparted by inkjet printing or the like, and the amount of metal derived from the plated metal film deposited by plating, hereinafter referred to as "total metal content".

The total metal content in the soft region of a plated electroconductive circuit pattern is preferably 3.0 µg/mm² or more, more preferably 5.0 µg/mm² or more, further preferably 10 µg/mm² or more, particularly preferably 30 µg/mm² or more, and even particularly preferably 35 µg/mm² or more. The upper limit thereof is not particularly limited, but it is preferably 120 µg/mm² or less, more preferably 100 µg/mm² or less, and particularly preferably 50 µg/mm² or less.

By increasing the total metal content in the soft region, the bending resistance of the soft region can be improved, which makes it possible to prevent a decrease in circuit reliability even with repeated bending and unfolding.

The amount of metal in the electroconductive circuit pattern in the hard region when plating is applied is not particularly limited, but it may be 39.9 µg/mm² or less, more preferably 29.9 µg/mm² or less. The lower limit is not particularly limited, but it may be 3 µg/mm² or more, more preferably 5 µg/mm² or more. The amount of metal in the hard region may be about the same as that in the soft region, or may be lower.

The electroconductive circuit pattern formed on the fiber substrate can have good conductivity, with a surface resistance value preferably less than 10 mΩ/□, more preferably less than 10 kΩ/□.

### (4) Soft Region and Hard Region

The electroconductive circuit panel of the present invention has a flexible soft region that exhibits a low bending strength and a rigid hard region that exhibits a higher bending strength than that of the soft region.

The bending strength of the electroconductive circuit panel in the soft region is preferably 0.19 N or less, more preferably 0.15 N or less, further preferably 0.1 N or less, and particularly preferably 0.07 N or less. The lower limit thereof is not particularly limited, but is preferably 0.01 N or more.

The bending strength of the electroconductive circuit panel in the hard region is preferably 0.2 N or more, more preferably 0.3 N or more. The upper limit thereof is not particularly limited, but it is preferably 20 N or less, more preferably 10 N or less.

The bending strength is measured using a bending stress measurement method based on the loop compression method (JIS L-1096 rigidity measurement). Details are described later in "Method for Evaluating Bending Strength".

In the present invention, the difference between the bending strength of the electroconductive circuit panel in the soft region and the bending strength of the electroconductive circuit panel in the hard region is preferably 0.2 N or more, more preferably 0.3 N or more.

The ratio of the bending strength of the electroconductive circuit panel in the soft region to the bending strength of the electroconductive circuit panel in the hard region is not particularly limited, but the lower limit is preferably [bending strength of soft region] : [bending strength of hard region] = 1:3 or more, more preferably 1:5 or more, and even more preferably 1:7 or more, and the upper limit thereof is preferably 1:300 or less, more preferably 1:200 or less.

The electroconductive circuit panel of the present invention is foldable along the highly flexible soft region, exhibiting excellent bending resistance even after repeated folding and unfolding, thus avoiding a decrease in conductivity and degradation of antenna performance due to damage. The hard region has high rigidity, allowing the electroconductive circuit panel to maintain its shape and stability in the unfolded state.

Furthermore, since the electroconductive circuit pattern in the soft region has high bending resistance, folding along the soft region does not degrade antenna performance, resulting in an electroconductive circuit panel for an unfolding antenna that maintains reliability even after repeated folding and unfolding of the antenna as a whole.

### (5) Surface Resin Layer

In the present invention, a surface resin layer can be provided at least on the hard region of the electroconductive circuit panel. That is, in the present invention, it is preferable that a surface resin layer is formed at least on the hard region of the panel composite material composed of a fiber substrate and an electroconductive circuit pattern.

Providing a surface resin layer enables to maintain strength and durability of the electroconductive circuit panel, and to set the panel to divide into a soft region and a hard region having different bending strengths within the same panel surface by devising how to provide the surface resin layer.

Examples of the resin constituting the surface resin layer include, not particularly limited to, a polyurethane resin, a polyester resin, a silicone resin, an epoxy resin, an acrylic resin, and a polyimide resin.

Among them, a polyurethane resin or an epoxy resin is preferred from the viewpoint of rigidity, durability or the like, and a polyurethane resin is particularly preferred. The resin may be compounded with curing agents, flame retardants, corrosion inhibitors or the like, if necessary.

The surface resin layer is needed to be formed on at least one side of the panel composite material, at least in the hard region. The surface resin layer may be formed on only one side or on both sides of the panel composite material.

Furthermore, the surface resin layer may be formed on the side of the panel composite material that the electroconductive circuit pattern is formed, or on the side that the electroconductive circuit pattern is not formed. In other words, in the case of a panel composite material in which the electroconductive circuit pattern is formed on only one side of the fiber substrate, when forming the surface resin layer on only one side of the panel composite material, the surface resin layer may be formed only on the side in which the electroconductive circuit pattern is formed, or only on the side in which the electroconductive circuit pattern is not formed.

Preferably, the surface resin layer is formed on the side of the panel composite material where the electroconductive circuit pattern is formed. More preferably, the surface resin layer is formed on both sides of the panel composite material.

When the electroconductive circuit panel of the present invention is used as a communication antenna requiring high sensitivity and accuracy, forming the surface resin layer on only one side of the panel composite material allows the side without the surface resin layer to be used as the receiving surface during use, which is expected to reduce noise caused by interference and may also contribute to simplified manufacturing processes and weight reduction.

Considering durability of the electroconductive circuit panel and protection of the electroconductive circuit, on the other hand, the surface resin layer can be formed on both sides of the panel composite material, thereby improving durability and sustainability of antenna performance.

In applications where protection of the electroconductive circuit pattern is not particularly necessary, forming the surface resin layer only on the side of the panel composite material without the electroconductive circuit pattern may make it easier to secure contacts with external devices or to attach and detach contacts by exposing the electroconductive circuit pattern.

The surface resin layer is preferably formed at least on the surface of the hard region of the panel composite material. It may also be formed only on the hard region. For example, by forming a surface resin layer on the surface of the hard region and not forming a surface resin layer on the surface of the soft region, the bending strength of the hard region can be increased, while the bending strength of the soft region can be relatively decreased.

The surface resin layer can be formed on both the soft and hard surfaces of the panel composite material. For example, by providing a difference between the amount of resin and thickness of the surface resin layer in the soft region and the amount of resin and thickness of the surface resin layer in the hard region, or by using different types of resins to constitute the surface resin layer in each region, the bending strength of the hard region of the resulting electroconductive circuit panel can be improved, while the bending strength of the soft region can be relatively decreased.

When the same type of resin is used for the surface resin layer in both the soft and hard regions, the amount of resin in the surface resin layer of the soft region is not particularly limited, but is preferably 0.2 mg/mm² or less, more preferably 0.1 mg/mm² or less. The lower limit of the resin amount is not particularly limited, but is preferably 0.01 mg/ mm² or more, more preferably 0.04 mg/mm² or more.

The amount of resin in the surface resin layer of the hard region is not particularly limited, but is preferably 0.21 mg/mm² or more, more preferably 0.4 mg/mm² or more, even more preferably 1 mg/mm² or more, and particularly preferably 3 mg/mm² or more. The upper limit of the resin amount is not particularly limited, but is preferably 10 mg/mm² or less, and more preferably 7 mg/mm² or less.

When using the same type of resin, the thickness of the surface resin layer in the soft region is not particularly limited, but is preferably 120 µm or less, more preferably 90 µm or less, and particularly preferably 60 µm or less. The lower limit of the thickness of the surface resin layer in the soft region is not particularly limited, but is preferably 10 µm or more, more preferably 20 µm or more, and particularly preferably 40 µm or more.

When using the same type of resin, the thickness of the surface resin layer in the hard region is not particularly limited, but is preferably 60 µm or more, more preferably 150 µm or more, even more preferably 300 µm or more, and particularly preferably 500 µm or more. The upper limit of the thickness of the surface resin layer in the hard region is not particularly limited, but is preferably 1500 µm or less, more preferably 1200 µm or less, and particularly preferably 900 µm or less.

When using the same type of resin, it is desirable that the ratio of the amount of resin in the surface resin layer of the soft region to the amount of resin in the surface resin layer of the hard region be preferably 1:20 or more (mass ratio), more preferably 1:30-100 (mass ratio), and particularly preferably 1:50-100 (mass ratio).

When using the same type of resin, it is desirable that the ratio of the thickness of the surface resin layer in the soft region to the thickness of the surface resin layer in the hard region be preferably 1:8 or higher, more preferably 1:10-20, and even more preferably 1:12-18.

In the electroconductive circuit panel of the present invention, the type of resin constituting the surface resin layer formed in the soft region can be different from the type of resin constituting the surface resin layer formed in the hard region. That is, by using a flexible resin with relatively low-rigidity as the resin constituting the surface resin layer in the soft region, and a resin having relatively high-rigidity as the resin constituting the surface resin layer in the hard region, the bending strength of the hard region can be enhanced and the bending strength of the soft region can be relatively lowered. This makes it possible to provide an electroconductive circuit panel having a soft region and a hard region with different bending strengths.

When different types of resin are used for the surface resin layer in the soft region and the hard region, examples of preferred resin types for the soft region include a polyurethane resin, an epoxy resin, a silicone resin, a polyester resin, and a polyimide resin. Among them, a polyurethane resin or an epoxy resin is preferred from the viewpoint of rigidity and durability, and a polyurethane resin is particularly preferred.

Examples of preferred resin types for the hard region include a polyester resin, a polyurethane resin, an epoxy resin, a polyimide resin, and an acrylic resin. Among them, a polyester resin or an acrylic resin is preferred from the viewpoint of rigidity and durability, and a polyester resin is particularly preferred.

The combination of the resin for the soft region and the resin for the hard region is not particularly limited. Preferably, the combination can be selected so that their flexibility differs with each other. For example, when a polyester resin is selected for the soft region, a resin with less flexibility can be selected for the hard region. When a polyester resin is selected for the hard region, a resin with higher flexibility can be selected for the soft region.

Selecting a combination of resins in this way enables to provide a difference in bending strength while minimizing the difference in thickness between the soft and hard regions, thereby making the overall thickness of the electroconductive circuit panel uniform.

The electroconductive circuit panel of the present invention has a soft region having an electroconductive circuit pattern that provides excellent flexibility to the panel while enhancing resistance to bending, and a hard region that provides high bending strength to the panel while an electroconductive circuit pattern can be formed with a high degree of freedom without worrying about bending resistance.

Furthermore, by minimizing the difference in thickness between the two regions to make the overall thickness of the electroconductive circuit panel uniform, an antenna with excellent appearance and usability can be obtained.

When different types of resin are used for the surface resin layers in the soft region and in the hard region, the amount of resin in the surface resin layer of the soft region is not particularly limited, but is preferably 0.2 mg/mm² or less, more preferably 0.1 mg/mm² or less. The lower limit of the resin amount is not particularly limited, but can be preferably 0.01 mg/mm² or more, more preferably 0.04 mg/mm² or more.

The amount of resin in the surface resin layer of the hard region is not particularly limited, but is preferably 0.1 mg/mm² or more, more preferably 0.12 mg/mm² or more. The upper limit of the resin amount is not particularly limited, but can be preferably 10 mg/mm² or less, more preferably 7 mg/mm² or less.

When using different types of resins for the surface resin layers in the soft region and in the hard region, the thickness of the surface resin layer in the soft region is not particularly limited, but is preferably 80 µm or less, more preferably 65 µm or less, and particularly preferably 52 µm or less. The lower limit of the thickness of the surface resin layer in the soft region is not particularly limited, but is preferably 10 µm or more, and more preferably 20 µm or more.

The thickness of the surface resin layer in the hard region is not particularly limited, but is preferably 55 µm or more, and more preferably 60 µm or more. The upper limit of the thickness of the surface resin layer in the hard region is not particularly limited, but is preferably 1000 µm or less, more preferably 500 µm or less, and particularly preferably 200 µm or less.

When using different types of resins, the ratio of the amount of resin in the surface resin layer of the soft region to the amount of resin in the surface resin layer of the hard region is not particularly limited, but is preferable to have a ratio of 1:1.5 or more (mass ratio), more preferably 1:2 or more (mass ratio), and particularly preferably 1:2-3 (mass ratio).

When using different types of resins, the ratio of the thickness of the surface resin layer of the soft region to the thickness of the surface resin layer of the hard region is not particularly limited, but is preferable to have a ratio of 1:1 or more, and more preferably 1:1-2.

For example, even if the type of resin constituting the surface resin layer in both regions is the same, the bending strengths of soft region and the hard region can be adjusted to enhance the bending strength of the hard region and make the bending strength of the soft region be relatively lower, by using different types of curing agents or using curing agents with a difference in the amount used for the resin in the soft region and the resin in the hard region.

In the case of using the same type of resin the surface resin layer, it is particularly preferred to use a polyurethane resin. Examples of the polyurethane resin include a reaction product obtained by reacting raw material components for polyurethane resin containing a polyisocyanate component and a polyol component.

Examples of polyisocyanate components include diisocyanates such as aliphatic diisocyanates, alicyclic diisocyanates, and aromatic diisocyanates.

As aliphatic or alicyclic diisocyanates, those having 4 to 30 carbon atoms are preferred. Examples of aliphatic diisocyanates include tetramethylene diisocyanate, 1,5-pentamethylene diisocyanate (PDI), 1,6-hexamethylene diisocyanate (HDI), 2,2,4-(or 2,4,4-) trimethyl-1,6-hexamethylene diisocyanate, and lysine diisocyanate.

Examples of alicyclic diisocyanates include isophorone diisocyanate, hydrogenated xylene diisocyanate, hydrogenated diphenylmethane diisocyanate, norbornane diisocyanate, 1,4-diisocyanate cyclohexane, 1,3-bis(diisocyanate methyl) cyclohexane, and 4,4'-dicyclohexylmethane diisocyanate.

Examples of aromatic diisocyanates include 1,3-xylene diisocyanate, 1,4-xylene diisocyanate, 2,4-tolylene diisocyanate, 2,6-tolylene diisocyanate, diphenylmethane diisocyanate, phenylene diisocyanate, dimethyl diphenylmethane diisocyanate, triphenylmethane triisocyanate, naphthalene diisocyanate, and polymethylene polyphenyl polyisocyanate.

These diisocyanates may be used individually or in combination. Among these, 1,6-hexamethylene diisocyanate is preferred due to its weather resistance and ease of industrial availability. Considering the impact on the environment, it is also preferable to use environmentally friendly 1,5-pentamethylene diisocyanate which is a plant-derived isocyanate.

The content ratio of the polyisocyanate component is preferably 35 parts by mass or more, more preferably 40 parts by mass or more, and particularly preferably 45 parts by mass or more, per 100 parts by mass of the polyurethane resin raw material component of the present invention. It is also preferably 80 parts by mass or less, more preferably 75 parts by mass or less, and particularly preferably 70 parts by mass or less.

Examples of polyol components include aromatic polyols, alicyclic polyols, aliphatic polyols, polyether polyols, polyester polyols, polylactone polyols, acrylic polyols, epoxy polyols, polycarbonate polyols, and urethane polyols. These may be used individually or in combination of two or more.

Examples of aromatic polyols include bisphenol A, bisphenol F, phenol novolac, and cresol novolac.

Examples of alicyclic polyols include cyclohexane diol, methylcyclohexane diol, isophorone diol, dicyclohexylmethane diol, and dimethyldicyclohexylmethane diol.

Examples of aliphatic polyols include ethylene glycol, propylene glycol, butanediol, pentanediol, and hexanediol.

Examples of polyether polyols include polymers obtained by ring-opening polymerization of at least one alkylene oxide such as ethylene oxide, propylene oxide, or tetrahydrofuran in the presence of at least one low molecular weight active hydrogen compound having two or more active hydrogen atoms. Examples of low molecular weight active hydrogen compounds having two or more active hydrogen atoms include diols such as bisphenol A, ethylene glycol, propylene glycol, butylene glycol, and 1,6-hexanediol; triols such as glycerin and trimethylolpropane; and amines such as ethylenediamine and butylenediamine.

Examples of polyester polyols include polyester polyol resins obtained by a condensation reaction of a dibasic acid, either alone or in mixtures, selected from carboxylic acids such as succinic acid, adipic acid, sebacic acid, dimer acid, maleic anhydride, fumaric anhydride, isophthalic acid, and terephthalic acid, with a polyhydric alcohol, either alone or in mixtures, such as ethylene glycol, propylene glycol, diethylene glycol, neopentyl glycol, trimethylolpropane, and glycerin; polycaprolactones obtained by ring-opening polymerization using ε-caprolactone and a polyhydric alcohol; and esters of aliphatic compounds having hydroxyl groups, such as castor oil, and polyhydric alcohols.

Examples of polylactone polyols include polypropiolactone glycol, polycaprolactone glycol, and polyvalerolactone glycol.

Examples of acrylic polyols include those obtained by copolymerizing a polymerizable monomer having one or more active hydrogen atoms in one molecule with a copolymerizable monomer.

Examples thereof include acrylic polyols obtained by polymerizing:
(i) acrylic acid compounds or methacrylic acid compounds having polyvalent active hydrogen, either alone or in mixtures, selected from the group consisting of acrylic acid esters having active hydrogen atoms such as 2-hydroxyethyl acrylate, 2-hydroxypropyl acrylate, and 2-hydroxylbutyl acrylate; methacrylic acid esters having active hydrogen atoms such as 2-hydroxyethyl methacrylate, 2-hydroxypropyl methacrylate, and 2-hydroxylbutyl methacrylate; glycerin acrylic acid monoester or methacrylic acid monoester; and trimethylolpropane acrylic acid monoester or methacrylic acid monoester; and
(ii) acrylic acid esters or methacrylic acid esters, either alone or in mixtures, selected from the group consisting of acrylates such as methyl acrylate, ethyl acrylate, isopropyl acrylate, n-butyl acrylate and 2-ethylhexyl acrylate; and methacrylates such as methyl methacrylate, ethyl methacrylate, isopropyl methacrylate, n-butyl methacrylate, isobutyl methacrylate, and n-hexyl methacrylate;
in the presence or absence of (iii) polymerizable monomers, either alone or in mixtures, selected from the group consisting of unsaturated carboxylic acids such as acrylic acid, methacrylic acid, and itaconic acid; unsaturated amides such as acrylamide and N-methylol acrylamide; and other polymerizable monomers such as styrene, vinyl toluene, vinyl acetate, and acrylonitrile.

Examples of epoxy polyols include novolac type epoxy resins, β-methyl epichlorohydrin type epoxy resins, cyclic oxirane type epoxy resins, glycidyl ether type epoxy resins, glycidyl ester type epoxy resins, glycol ether type epoxy resins, epoxidized aliphatic unsaturated compound type epoxy resins, epoxidized aliphatic ester type epoxy resins, polycarboxylic acid ester type epoxy resins, aminoglycidyl type epoxy resins, and resorcinol type epoxy resins.

Examples of polycarbonate polyols include polyols obtained by a dealcoholization reaction of hydroxyl group-containing compounds such as ethylene glycol, propylene glycol, butanediol, pentanediol, hexanediol, octanediol, and nonanediol with carbonates such as diethylene carbonate and dipropylene carbonate. Polycarbonate polyols obtained using aromatic polyhydric alcohols such as bisphenol A and aliphatic/alicyclic polyhydric alcohols such as 1,6-hexanediol as raw materials are also included.

Examples of urethane polyols include polymers having urethane bonds in the polymer and hydroxyl groups in the polymer side chains or terminals, which can be produced by a polyaddition reaction of aromatic, aliphatic, or alicyclic diisocyanates with active hydrogen compounds.

Examples of other polyol components include polybutadiene polyols, modified polyols of polyhydric alcohols, and hydrogenated products thereof.

Examples of modified polyols of polyhydric alcohols include those obtained by reacting a polyhydric alcohol raw material with alkylene oxide to modify it.

Examples of polyhydric alcohols include trihydric alcohols such as glycerin and trimethylolpropane; tetrahydric to octahydric alcohols such as pentaerythritol, sorbitol, mannitol, sorbitan, diglycerin, dipentaerythritol, sucrose, glucose, mannose, fructose, methyl glucoside and derivatives thereof; phenols such as phenol, phloroglucin, cresol, pyrogallol, catechol, hydroquinone, bisphenol A, bisphenol F, bisphenol S, 1-hydroxynaphthalene, 1,3,6,8-tetrahydroxy naphthalene, anthrol, 1,4,5,8-tetrahydroxy anthracene, and 1-hydroxy pyrene; polybutadiene polyol; castor oil polyol; polyfunctional polyols having 2 to 100 functional groups such as (co)polymers of hydroxyalkyl (meth)acrylates and polyvinyl alcohols, and condensates of phenol and formaldehyde (novolacs).

The method for modifying polyhydric alcohols is not particularly limited, but a method of adding alkylene oxides (hereinafter, "AO") is preferably used. Examples of AOs include those having 2 to 6 carbon atoms, such as ethylene oxide (hereinafter, "EO"), 1,2-propylene oxide (hereinafter, "PO"), 1,3-propylene oxide, 1,2-butylene oxide, and 1,4-butylene oxide.

Among these, PO, EO, and 1,2-butylene oxide are preferred from the viewpoint of properties and reactivity, and PO and EO are more preferred.

When using two or more types of AOs (for example, PO and EO), the addition method may be block addition, random addition, or a combination thereof.

Among the above polyols, polycarbonate polyol is preferable from the viewpoint of durability and the like. Considering the impact on the environment, it is also preferable to use sebacic acid-based polyol obtained from plant-derived sebacic acid, or castor oil polyol derived from castor oil.

The content ratio of the polyol component is preferably 35 parts by mass or more, more preferably 40 parts by mass or more, particularly preferably 45 parts by mass or more, and also preferably 80 parts by mass or less, more preferably 75 parts by mass or less, particularly preferably 70 parts by mass or less, per 100 parts by mass of the polyurethane resin raw material component of the present invention.

The content ratio of the polyol component is preferably 30 parts by mass or more, more preferably 35 parts by mass or more, particularly preferably 40 parts by mass or more, and also preferably 70 parts by mass or less, more preferably 65 parts by mass or less, particularly preferably 60 parts by mass or less, per 100 parts by mass of the polyurethane resin raw material component of the present invention.

### (3) Other raw material components

In the present invention, in addition to the polyisocyanates component and polyol components described above, crosslinking agents, chain extenders, curing accelerators (catalyst components), organic solvents or the like may be included as raw material components for the polyurethane resin, if necessary.

Furthermore, foaming agents, defoaming agents, thickeners, surface modifiers, surfactants, fillers, weather resistance improvers, ultraviolet absorbers, water, dispersants, color pigments, pH adjusters, etc. may also be included.

For chain extenders, not particularly limited, relatively low molecular weight diols are generally used.

Examples of such diols include petroleum-derived diols such as ethylene glycol, diethylene glycol, propanediol, butanediol, hexanediol, and PEG, and plant-derived diols such as 1,3-propanediol and 1,2-hexanediol.

These diols may be used alone, or two or more may be used in combination, if necessary. Diamines may also be used as necessary. The amount of chain extender used is not particularly limited, but is preferably about 1 to 5 parts by mass per 100 parts by mass of the polyurethane resin.

A curing accelerator, or a catalyst component, can also be used. Examples thereof include metal-based catalysts such as titanium diisopropoxy-bis(ethyl acetate), amine-based catalysts, and DBU-based catalysts. The amount of curing accelerator used is not particularly limited, but is preferably about 0.01 to 1 part by mass per 100 parts by mass of the polyurethane resin.

Examples of the organic solvents include, but not particularly limited, polar solvents that are inert to isocyanate groups such as dimethylformamide (DMF) and dimethyl sulfoxide (DMSO), and organic solvents such as methyl ethyl ketone (MEK), toluene, and xylene.

The polyurethane resin preferably used as the resin constituting the surface resin layer in the present invention can be obtained by molding a polyurethane resin raw material component containing the above-mentioned polyisocyanate component, polyol component, and other raw material components used as needed, and then performing drying, heating, and curing treatments as necessary.

The molar ratio of the polyisocyanate component to the polyol component is preferably polyisocyanate component/polyol component = 0.6/1 to 1.8/1. If either the polyisocyanate component or the polyol component is too abundant, it might be difficult to obtain a resin layer that exhibits durability and toughness.

The number-average molecular weight of the polyurethane resin obtained in this manner is preferably 2000 or more, and more preferably 2500 or more. The upper limit of the number-average molecular weight is not particularly limited, but is usually 200,000,000 or less, preferably 100,000,000 or less. When the number-average molecular weight of the polyurethane resin is within the above range, a resin suitable for forming a surface resin layer can be obtained.

### (6) Manufacturing Method

The electroconductive circuit panel of the present invention can be manufactured by a method which comprises a pattern forming step of forming an electroconductive circuit pattern on a fiber substrate to produce a panel composite material, and a surface resin layer forming step of forming a surface resin layer on the surface of the panel composite material.

If necessary, a plated metal film forming step of forming a plated metal film on the electroconductive circuit pattern may also be included following the pattern forming step.

In the pattern forming step, an electroconductive circuit pattern is formed on the fiber substrate. The electroconductive circuit pattern may be formed on one side of the fiber substrate or on both sides. The electroconductive circuit pattern is preferably formed using the above-mentioned ink composition containing metal.

A printing method is preferably used to form the electroconductive circuit pattern. A particularly preferred printing method is an inkjet printing method. The ink composition is preferably an ink composition containing metal particles. In particular, it is preferable that it contains metal particles with an average particle diameter of 1 to 200 nm. Examples of the ink composition include a dispersion of metal particles.

In the pattern forming step, the electroconductive circuit pattern can be formed with a difference in the line width and metal thickness in the soft and hard regions. In order to improve flexibility in the soft region, for example, it is desirable to make the line width of the electroconductive circuit pattern in the soft region thicker than in the hard region, or to adjust the amount of metal in the electroconductive circuit pattern in the soft region greater than that in the hard region.

Means for achieving this include, in an inkjet printing process, a method of setting in advance to increase the ink ejection amount only in the soft region or to widen the ink ejection area to increase the line width, thereby printing to achieve the desired amount of metal and/or line width.

Examples of methods for forming the electroconductive circuit pattern of the present invention by the inkjet printing process include, but are not limited to, a method of using a line-type printing device equipped with multiple nozzles while making differences in the amount and density of ink applied at each nozzle, and a scanning printing method using a single nozzle that can move in the vertical and horizontal directions while adjusting the desired amount of metal applied at the single nozzle.

Examples of methods for forming the electroconductive circuit pattern of the present invention also include, but are not limited to, a screen printing method wherein two plates, a pattern for the soft region and a pattern for the hard region, are prepared to print twice to form the pattern.

A method for forming an electroconductive circuit pattern by applying a metal-containing ink composition to the surface of a fiber substrate using a piezo-type inkjet printing apparatus will be explained as an example below.

In an inkjet printing apparatus having an inkjet head equipped with multiple nozzles, ink is supplied from the ink tank through an ink supply path to the inkjet head in which piezoelectric elements are arranged for each nozzle.

Next, image data corresponding to the electroconductive circuit pattern to be formed is created to define the soft region and the hard region. The image data holds the target amount of metal imparted to the soft area and the hard area, respectively.

Based on the image data, each region of the electroconductive circuit pattern is associated with each nozzle of the inkjet head, and an electrical signal is sent to a piezoelectric element provided on each nozzle. The piezoelectric element, upon receiving the electrical signal, is driven, causing ink to be ejected as nozzle droplets.

In a multi-nozzle system, each nozzle can have a different ejection amount (or coating amount) by adjusting the ink ejection pressure and the like. Using this function, the ink ejection amount can be adjusted for each nozzle to achieve the target metal content set based on the image data. This allows the printed conductive circuit pattern to have the desired amount of metal in each region.

When using an inkjet printing device with a single nozzle such as a scanning printer, the amount of metal in the soft and hard regions can be controlled by scanning the single nozzle vertically and horizontally while ejecting at a controlled ejection amount or controlled droplet size.

Next, in the plated metal film forming step, which is performed as needed, a metal plating treatment is applied to the electroconductive circuit pattern obtained in the pattern forming step to form a plated metal film. Examples of metal plating treatments include electroplating and electroless plating, and either is acceptable. Preferably, electroless plating is used.

Conventionally known methods can be employed for the metal plating treatment, and there are no particular limitations on the chemicals, equipment, or conditions used. Optimal conditions can be selected and implemented depending on the type and amount of metal to be deposited.

When performing electroless plating, for example, an electroconductive circuit pattern is printed on a fiber substrate using an ink composition, and then the solvent of the ink composition is removed by heating or drying. Next, the fiber substrate is immersed in an electroless plating solution to be subjected to electroless plating.

In the present invention, a panel composite material comprising a fiber substrate, an electroconductive circuit pattern formed on said fiber substrate and a plated metal film formed if necessary can be obtained through the pattern forming step and a plated metal film forming step performed if necessary.

In the surface resin layer forming step as a next step, a surface resin layer is formed on the surface of the obtained panel composite material. Examples of means for forming a surface resin layer for each region of the panel composite material include a method of applying a resin coating solution to the surface of the panel composite material and a method of cutting out resin sheets for each region from a raw resin sheet and bonding them to the substrate, but are not limited to these, and various conventionally known methods can be used.

Preferable examples of means for applying a resin coating solution include a method for applying it to the surface of the panel composite material using an inkjet method. Preferable examples of solvents used in the resin coating solution include diacetone alcohol, MEK, and DPMA. The concentration of the resin coating solution is preferably 3.0 to 40.0% by mass. After application, the solvent can be removed by heating and drying.

Applying the resin coating solution to the soft region, which is a bending portion, and the hard region separately can be achieved creating a design drawing and/or image data of the panel to be manufactured in advance to define the soft region and the hard region, and then performing inkjet printing based thereon. More particularly, by setting the coating amount for each area based on the panel design drawing or image data in the inkjet printer, and coating the soft and hard regions with different coating amounts, for example, a surface resin layer with different film thickness and bending strength can be formed in the soft and hard regions.

Another means of forming a surface resin layer on the panel composite material is to separately manufacture a raw resin sheet for the surface resin layer in advance, cut it to the shape and dimensions of each region based on the panel design drawing, and then bond the cut resin sheet for each region to the surface of the panel composite material. It is preferable to manufacture a resin sheet for the soft region and a resin sheet for the hard region separately, each with different film thickness and bending strength, depending on the desired panel design.

Means for bonding is not particularly limited, but a resin sheet for the soft region and a resin sheet for the hard region, which have been cut out according to the shape and dimensions based on the panel design drawing, can be to the panel composite material according to the panel design drawing, after applying adhesives to the panel composite material as needed. A heat press can be used for bonding. Known methods can be appropriately used for the heat press conditions, but preferably the temperature is 100 to 200°C, the pressure is 0.1 to 2.0 MPa, and the time is 0.5 to 10 minutes.

The electroconductive circuit panel for unfolding antenna of the present invention has a soft region exhibiting low bending strength and a hard region exhibiting higher bending strength than the soft region, which is an electroconductive circuit panel for a deployable antenna that can be both in a folded state and in an unfolded state, and is foldable along the soft region.

The size of the electroconductive circuit panel for an unfolding antenna of the present invention can be appropriately set according to the application. For example, in the case of an unfolding antenna mounted on an artificial satellite, a size of approximately 1.0 x 10.0 m is expected.

For general applications such as outdoor use or emergency supplies, the size varies depending on the application. For the application of a portable LED light-emitting sheet, for example, a size of approximately 200 x 300 mm is expected.

The thickness of the electroconductive circuit panel is not particularly limited, but is preferably about 0.1 to 2.0 mm.

### Examples

Hereinafter, the present invention will be described with reference to examples, but the present invention is not limited to these examples. The evaluation methods for various properties in the examples are as follows.

### <Method for Measuring Metal Content>

The measurement target area of the electroconductive circuit pattern in a composite panel material composed of a fiber substrate and an electroconductive circuit pattern was cut out together with the fiber substrate to obtain a test sample having a size of approximately 30 mm x 30 mm, and its area was measured.

Then, the cut-out sample was immersed in nitric acid diluted to a concentration of 50% by mass to completely dissolve the metal layer to obtain an aqueous solution in which the metal was dissolved.

The aqueous solution thus obtained was diluted to a predetermined concentration and the metal concentration in the aqueous solution was measured by atomic absorption spectrometry.

The amount of metal per unit area (µg/mm²) was calculated from the area of the cut-out sample and the metal concentration obtained by atomic absorption spectrometry.

### <Evaluation for Bending Resistance of Electroconductive Circuit Pattern>

Bonding resistance of the electroconductive circuit patterns was evaluated using the MIT bending test described below to determine the resistance increase rate.

The measurement target area of the electroconductive circuit pattern in a composite panel material composed of a fiber substrate and an electroconductive circuit pattern was cut out together with the fiber substrate to obtain a test sample (width: arbitrary, length: 200 mm).

First, the resistance value of the electroconductive circuit pattern before starting the bending test was measured using the four-terminal method and defined as the initial resistance value.

Furthermore, the increase in the resistance value of the electroconductive circuit pattern after starting the bending test was defined as the resistance increase value, and the ratio of the resistance increase value to the initial resistance value was defined as the resistance increase rate (%).

The above-obtained test sample was set in an MIT testing apparatus, product name "Tabletop Bending Tester", manufactured by Yuasa System Equipment Co., Ltd., and a bending test was performed with a load (tension) of 250 g, bending device tip radius R = 0.38 mm, bending speed of 90 times/min, and bending angle of 135 degrees to the left and right, and the number of bending of 1000 times.

The resistance value of the electroconductive circuit pattern after the bending test was measured using the four-terminal method, and the resistance increase rate (%) was determined based on the above definition.

### <Method for Evaluating Bending Strength of Electroconductive Circuit Panel>

Bending strength was evaluated using a bending stress measurement method based on the loop compression method (JIS L1096 method). A schematic diagram of the measurement method is shown in FIG. 5. The test piece 5 was cut into a ribbon shape of 10 mm x 50 mm, and then both ends of the test piece 5 were clamped at 10 mm from each end in a vise jig 6 to form a loop (FIG. 5, (A)).

The pressure element 7 having a indentation width of 8 mm and a tip angle of 85° was set so that its center line coincided with the center line of the loop-shaped test piece 5. Then, the pressure element 7 was lowered, with a head speed of 50 mm/min, vertically onto the test piece 5 from the position having a distance L of 20 mm, applying force to the test piece 5 from the center of the loop. The pressure element 7 was continued to lower until the loop was crushed (FIG. 5, (B)), and the pressure applied to the pressure element 7 when the loop was completely crushed was measured to obtain a resulting value which was defined as the bending strength. The test was performed three times, and the average value was calculated.

FIG. 6 shows a schematic diagram of the pressure element. In FIG. 6, (a) is a front view of the pressure element, (b) is a side view thereof, and (c) is a perspective view thereof.

### <Method for Measuring Resin Content of Electroconductive Circuit Panel>

A resin sheet for each region prepared for the surface resin layer, before cutting and laminating for each region, was cut into a 100 mm x 100 mm piece as a measurement sample.

Then, the weight of the measurement sample was measured using an electronic balance. The amount of resin per unit area (mg/mm²) per sheet was calculated from the area of the measurement sample and the weight measured by the electronic balance.

The resulting amount of resin per sheet was then multiplied by the number of sheets laminated to the panel composite material (or the number of layers of the panel composite material) to determine the amount of resin per unit area of the electroconductive circuit panel.

### [Example 1]

An electroconductive circuit panel for an unfolding antenna, as shown in FIG. 1, was prepared. In FIG. 1, 1 is the electroconductive circuit panel, 2 is the hard region, and 3 is the soft region. The electroconductive circuit pattern was formed as shown in FIG. 4.

### (1) Pattern Forming step

A polyester plain weave fabric (warp: polyester processed yarn 33dtex/36f, weft: polyester processed yarn 69dtex/150f, weave density: warp 189 threads/25.4 mm, weft 120 threads/25.4 mm, thickness: 90 µm) was used as the fiber base material.

As an ink composition containing metal particles, product name "IJ-02", manufactured by Ishihara Chemical Co., Ltd., was used. The ink composition contained 35-45% by mass of copper particles with an average particle size of 70 nm, 50-60% by mass of diethylene glycol monobutyl ether, and less than 5% by mass of an activator.

The ink composition was applied to the fiber substrate using an inkjet printing device with the number of nozzles of 3 or more, product name "SIT-M10", manufactured by Seiren Co., Ltd., to form an electroconductive circuit pattern having the shape shown in FIG. 4 on the fiber substrate. The line width in the soft region was 5.0 mm, and the line width in the hard region was 1.0 mm.

The ink composition was penetrated the fiber substrate so as to permeate in the thickness direction of the fiber substrate, resulting in penetrating from the front to the back surface of the fiber substrate to be in a state where an electroconductive circuit pattern is formed substantially on both sides of the fiber substrate.

### (2) Plating Metal Film Forming step

A fiber substrate printed with an electroconductive circuit pattern was immersed for 20 minutes in an electroless copper plating solution at 40°C containing 8.75 g/L of copper chloride dihydrate, 20 g/L of an urethane resin "EDP-300" manufactured by ADEKA Corporation, 40 mL/L of 32% by mass sodium hydroxide aqueous solution, and 8.75 mL/L of 37% by mass formaldehyde aqueous solution to perform electroless plating. Then, it was subjected to rinsing with water and drying in a 65°C oven for 10 minutes.

In this way, a panel composite material was obtained in which a plated metal film was formed on the electroconductive circuit pattern on the fiber substrate.

The total amount of metal per unit area of the electroconductive circuit pattern in the panel composite material thus obtained was 38.6 µg/mm² in both the soft and hard regions. The total amount of metal is the sum of the metal derived from the ink composition by inkjet printing and the metal derived from the plated metal film formed in the plating process.

The resistance increase rate of the electroconductive circuit pattern in the panel composite material thus obtained, as measured by the MIT bending test, was 410% in the soft region and 960% in the hard region.

The surface resistance of the electroconductive circuit pattern in the panel composite material thus obtained, measured using the four-terminal method, was 50 mΩ/□.

### (3) Surface Resin Layer Forming step

A polyurethane resin sheet for the soft region which was a polycarbonate-based polyurethane resin having a thickness of 25 µm, manufactured by Seiren Co., Ltd., and a polyurethane resin sheet for the hard region having a thickness of 80 µm, product name "123 Premier", manufactured by BIOTEC Co., Ltd., were prepared.

According to the design drawing of a panel having a soft region and a hard region as shown in FIG. 1, a cut resin sheet for the soft region and a cut resin sheet for the hard region were cut in a pattern shape from each polyurethane resin sheet using a laser cutting machine.

The cut resin sheet for each region thus obtained were bonded to both sides of the panel composite material where the electroconductive circuit pattern was formed, in the arrangement shown in the panel design drawing in FIG. 1, by hot pressing from both sides at a temperature of 180°C for the soft region resin and at a temperature of 130°C for the hard region resin to obtain an electroconductive circuit panel.

In the soft region, a cut resin sheet having a thickness of 25 µm was bonded to each side of the panel composite material, bonding two sheets in total, resulting in a total surface resin layer thickness of 50 µm.

In the hard region, five cut resin sheets each having a thickness of 80 µm were bonded to each side of the panel composite material, bonding 10 sheets in total, resulting in a total surface resin layer thickness of 800 µm.

In a concrete process, cut resin sheets were bonded to the soft region first, followed by hot pressing at a temperature of 180°C under a pressure of 0.7 MPa for 5 minutes, and then cut resin sheets were bonded to the hard region, followed by hot pressing again at a temperature of 130°C under a pressure of 0.7 MPa for 1 minute.

In the electroconductive circuit panel thus obtained, the resin content in the soft region was 0.05 mg/mm², and the resin content in the hard region was 3.64 mg/mm².

The bending strength of the electroconductive circuit panel thus obtained was measured to be 0.04 N in the soft region and 7.6 N in the hard region.

### [Example 2]

An electroconductive circuit pattern was formed on a fiber substrate and a panel composite material was manufactured using the same manner as in Example 1

A polyurethane resin sheet for the soft region having a thickness of 25 µm which was a polycarbonate-based polyurethane resin manufactured by Seiren Co., Ltd., and a polyester resin sheet for the hard region having a thickness of 30 µm, product name "Lumirror", manufactured by Toray Industries, Inc., were prepared.

According to the design drawing of a panel having a soft region and a hard region as shown in FIG. 1, a cut resin sheet for the soft region and a cut resin sheet for the hard region were cut in a pattern shape from the resin sheet for each region using a laser cutting machine.

The cut resin sheets for each region thus obtained were bonded to both sides of the panel composite material where the electroconductive circuit pattern was formed, in the arrangement shown in the panel design drawing in FIG. 1, by hot pressing from both sides at a temperature of 180°C for the soft region resin and at a temperature of 110°C for the hard region resin to obtain an electroconductive circuit panel.

In the soft region, a cut resin sheet having a thickness of 25 µm was bonded to each side of the panel composite material, bonding two sheets in total, resulting in a total surface resin layer thickness of 50 µm.

In the hard region, a cut resin sheet having a thickness of 30 µm was bonded to each side of the panel composite material, bonding two sheets in total, resulting in a total surface resin layer thickness of 60 µm.

In a concrete process, cut resin sheets were bonded to the soft region first, followed by hot pressing at a temperature of 180°C under a pressure of 0.7 MPa for 5 minutes, and then cut resin sheets were bonded to the hard region, followed by hot pressing again at a temperature of 110°C under a pressure of 0.7 MPa for 0.5 minutes.

The electroconductive circuit panel thus obtained had little difference in thickness between the soft and hard regions, resulting in a panel with a relatively uniform overall thickness.

In the electroconductive circuit panel thus obtained, the resin content in the soft region was 0.05 mg/mm², and the resin content in the hard region was 0.14 mg/mm².

The bending strength of the electroconductive circuit panel thus obtained was measured, resulting in 0.04 N in the soft region and 0.4 N in the hard region.

### Industrial Applicability

The electroconductive circuit panel for an unfolding antenna of the present invention can be stored in a folded state and can be unfolded to expand the transmission/reception surface when in use. A hard region and a soft region can be set within a single panel. The soft region has an electroconductive circuit pattern that provides excellent flexibility to the panel while enhancing resistance to bending. By folding along the soft region, deterioration of a circuit or a panel due to repeated folding and unfolding is prevented, and shape stability can be maintained when deployed.

By setting the bending portion at the time of manufacture, a highly reliable unfolding antenna can be obtained.

In the hard region, the bending strength of the panel is increased while the electroconductive circuit pattern can be formed without worrying about bending resistance, which provides advantages such as the improved degree of freedom of the electroconductive pattern in the hard region, which is a major part of antenna performance, and space saving.

The combination of such soft and hard regions enables to maintain a well-balanced and excellent antenna performance overall.

The electroconductive circuit panel for an unfolding antenna of the present invention is particularly useful for aerospace applications such as artificial satellites, as it can be mounted on an artificial satellite with folded and stored compactly during launch, and unfolded in orbit to obtain a large area fora a transmission/reception surface. It is also useful for general applications such as an outdoor use and emergency supplies, which can be utilized as a portable LED light-emitting sheet, for example, by mounting LEDs on the electroconductive circuit.

### Description of Reference Numerals

1 Electroconductive circuit panel
2(a) Hard region
2(b) Hard region
3(a) Soft region
3(b) Soft region
M Central part
4 Electroconductive circuit pattern
5 Test sample
6 Vice jig
7 Pressure element
8 Pressure element insertion width (8 mm)
9 Pressure element tip angle (85°)

## Claims

1. An electroconductive circuit panel for an unfolding antenna, which comprises a panel composite material composed of a fiber base material and an electroconductive circuit pattern formed on said fiber base material which can be in a folded state and an unfolded state,
wherein there are provided a soft region that exhibits a low bending strength and a hard region that exhibits a bending strength higher than that of the soft region,
said electroconductive circuit pattern has a resistance increase rate of 600% or less in the soft region, as measured in an MIT bending test in conformance with JIS-P8115, and
said electroconductive circuit panel can be folded along the soft region.

2. The electroconductive circuit panel for an unfolding antenna according to claim 1, wherein the bending strength of the soft region is 0.19 N or less and the bending strength of the hard region is 0.2 N or more.

3. The electroconductive circuit panel for an unfolding antenna according to claim 1, wherein the difference between the bending strength of the soft region and the bending strength of the hard region is 0.2 N or more.

4. The electroconductive circuit panel for an unfolding antenna according to claim 1, wherein the line width of said electroconductive circuit pattern in the soft region is 1.0 mm or more.

5. The electroconductive circuit panel for an unfolding antenna according to claim 1, wherein the metal content of the electroconductive circuit pattern in the soft region is 3 to 120 µg/mm².

6. The electroconductive circuit panel for an unfolding antenna according to claim 1, wherein a surface resin layer is formed on at least one side of the panel composite material in at least the hard region.

7. The electroconductive circuit panel for an unfolding antenna according to claim 6, wherein said surface resin layer is formed on at least one side of the panel composite material in both the soft region and the hard region, and the ratio of the amount of resin in the surface resin layer in the soft region to the amount of resin in the surface resin layer in the hard region is 1:20 or more by mass.

8. The electroconductive circuit panel for an unfolding antenna according to claim 6, wherein the surface resin layer is made of polyurethane resin.

9. The electroconductive circuit panel for an unfolding antenna according to claim 1, wherein the panel composite material comprises a plated metal film formed on said electroconductive circuit pattern.
